# EUROPEAN PATENT SPECIFICATION

(11) **EP 0 810 748 B1**
(45) Date of publication and mention of the grant of the patent: **21.03.2001**
(21) Application number: 96108813.5
(22) Date of filing: 01.06.1996
(51) Int. Cl.: H04B 10/08, H01S 3/083

(54) **Arrangement and method for operating and testing an optical device**
Vorrichtung und Verfahren zum Betreiben und Prüfen einer optischen Vorrichtung
Arrangement et procédé pour opérer et tester un dispositif optique

(43) Date of publication of application: 03.12.1997
(73) Proprietor: Hewlett-Packard Company, Palo Alto, California 94304-1112 (US)
(72) Inventor: Leckel, Edgar, 71131 Jettingen (DE); Müller, Emmerich, 71134 Aidlingen (DE)
(74) Representative: Kurz, Peter

(56) References cited:
- EP-A- 0 667 688
- EP-A- 0 716 515
- ELECTRONICS LETTERS, vol. 31, no. 25, 7 December 1995, page 2175/2176 XP000546800 RANKIN G ET AL: "AGILE, TUNABLE CHIRPED LASER WITH LOW BACKGROUND EMISSION"
- PHOTONIC SWITCHING, KOBE, APRIL 12 - 14, 1990, no. -, 12 April 1990, TADA K;HINTON H S, pages 241-244, XP000333164 OSHIBA S ET AL: "TUNABLE FIBER RING LASERS WITH AN ELECTRICALLY ACCESSIBLE ACOUSTO-O PTIC FILTER"
- HEWLETT-PACKARD JOURNAL, vol. 44, no. 1, February 1993, PALO ALTO, US, pages 11-19, XP000359156 MAISENBACHER ET AL: "Tunable laser sources for optical amplifier testing"
- PROCEEDINGS OF TRENDS IN OPTICAL FIBRE METROLOGY AND STANDARDS (NATO), 27 June 1994 - 8 July 1994, PORTO, PT, pages 511-525, XP000609657 MALZAHN: "EDFA Testing"

## Description

This invention relates to an optical source according to the preamble to claim 1.

### BACKGROUND OF THE INVENTION

Arrangements and methods for the operational test of active and passive optical devices, such as amplifiers, are commonly used in optical communication systems. In practice there is a need for testing wavelength dependent devices or components for their wavelength dependence. This requires testing of several device parameters over a single wavelength and testing with multiple wavelengths. Testing at a single wavelength is easily achieved with a laser source. For testing over a wavelength range, commonly a tunable laser or other sources are used.

In practice there is a need to test devices with multiple wavelengths applied at the same time. Such devices are, for example, EDFA's used in wavelength division multiplexing (WDM) applications. For such applications, it is known to use several single wavelength laser sources or a set of tunable laser sources. As several laser sources are needed to perform these tests in the mentioned applications, the test equipment is very expensive and difficult to handle.

Oshiba et al in Photonic Switching, Kobe, April 12-14, 1990, pages 241 to 244, XP 000333164, "Tunable Fiber Ring Lasers with an Electrically Accessible Acousto-optic Filter" discloses a tunable fiber ring laser with wavelength controllable from 1285 to 1367 nm by changing the frequencies of the acoustic shear waves in acousto-optic filters. A gain medium is coupled to an acousto-optical filter in a ring configuration by means of polarization maintaining fibers.

Rankin et al in Electronics Letters, Vol. 31, No. 25, 7 December 1995, page 2175/2176, XP 000546800, "Agile, tunable, chirped laser with low background emission" discloses a unidirectional ring configuration with polarization maintaining fibers connecting an acousto-optic tunable filter and a gain chip/beam splitter module, which contains an isolator, a polarizer, and gradient index lenses. To span the optical tuning range, the acousto-optical tunable filter is driven by a radiofrequency sweeper, thus determining the wavelength of the optical source.

### SUMMARY OF THE INVENTION

It is an object of the present invention to provide an improved optical source. This is solved by the features of claim 1. Preferred embodiments are given by the dependent claims.

The optical source according to the invention is in particular suitable for a multiplexed laser source which generates multiple wavelengths so that the component, device or system under test, having a recovery time, reacts in the same way, as it does when many single laser sources are applied at the same time. Such a multiplexed laser source is described in the older application EP-A-716515 (by the same applicant) which has been published after the application date of the present invention. The multiple wavelengths generated by a tunable laser or another source are time multiplexed so fast that the component, device or system under test, having a recovery time, does not recognize that the different wavelengths are applied one after the other. The device under test can be any optical device in the field of laser technology which exhibits the mentioned recovery time, such as optical devices in optical communication networks, biological and chemical substances, particularly cells and DNA-structures and photosensitive drums in laser printers etc.

According to one embodiment of the invention the device under test is an optical amplifier, in particular an erbium-doped fiber amplifier (EDFA) or a praseodymiumdoped fiber amplifier (PDFA). An important parameter to measure is the gain and noise figure of this amplifier. In future applications this amplifier may be used in wavelength division multiplexed systems. In the current state, these systems use four different channels (wavelengths) to transmit optical signals. Thus, for a complete operational test of the amplifier, four optical signals with different wavelengths have to be applied for operation and testing. Due to the physics of the EDFA, the recovery time from the noise level with signal applied to the amplifier to the noise level without signal is slow, i.e. within about 10 milliseconds (typical recovery time of an EDFA or PDFA), the noise level increases from a very low level to a stable level. According to the invention, four different wavelengths generated by a single tunable laser are applied, one after the other, to the device under test within its recovery time, so that the device under test does not recognize that there is only one wavelength signal present at a time. Preferably, all different wavelengths are applied within a time interval from 10 to 30 microseconds, particularly 12-15 microseconds, i.e. at low recovery.

The main advantage of the multiplexed laser source is that one single fast multiplexed tunable laser source is sufficient to operate a device with several channels or to perform the same measurements as a set of laser sources, each generating a signal with a single wavelength. The operation of the mentioned tests at multiple wavelengths can be performed less expensive and more easily than by a set of lasers.

A tunable laser may be used to generate the multiple optical signals for the multiplexed laser source. A tunable laser allows generation of optical signals with different wavelengths, one after the other. The control input of the tunable laser may be connected to the output of a pattern generator. The pattern generator multiplexes the multiple different wavelength signals generated by the tunable laser. The pattern generator enables adjustment over a wide range of the time interval between switching from one wavelength to another of the signals generated by the tunable laser. The pattern generator can be substituted by any other device which switches the tunable laser from one wavelength to another within low recovery of the device under test.

A source generating several wavelengths at the same time may also be used instead of the multiplexed laser source. A rotating set of filters transparent at the different wavelengths at which the device operates are disposed between the output of the white light source and the input of the optical component, device or system to be tested. The rotation of the set of filters is carried out in such a manner that the different wavelengths of the light generated by the source are applied to the device under test or under operation, one after each other, within the recovery time of the device under test.

The optical device to be tested or to be operated is preferably an amplifier, in particular an erbium-doped fiber amplifier (EDFA) which can be used in wavelength division multiplexing applications and works under multiple wavelengths simultaneously.

It is understood and expressly noted that the present invention relates to all useful and novel combinations of the above disclosed features, whether alone or in any other arbitrary combination. Furthermore, all cited advantages can be seen as objects solved by the invention in its entirety.

### BRIEF DESCRIPTION OF THE DRAWINGS

For better understanding of the present invention, together with other and further objects, advantages and capabilities thereof, reference is made to the accompanying drawings, which are incorporated herein by reference and in which:
- Fig. 1: depicts a block diagram of an arrangement generating multiple input signals for testing an erbium-doped fiber amplifier (EDFA) according to prior art;
- Fig. 2: shows a block diagram of a first arrangement for testing an optical device according to the invention comprising a pattern generator controlling the time interval between the different signals generated by a tunable laser;
- Fig. 3: depicts the control signal generated by the pattern generator in Fig. 2 as a function of time.
- Fig. 4: shows a block diagram of a second arrangement for testing or operating an optical device comprising a further laser with regard to Fig. 3 being separately adjustable;
- Fig. 5: shows an optical source according to the invention which allows to generate coherent signals with various wavelengths one after another at low recovery of optical amplifiers;
- Fig. 6: is a diagram showing output laser power of signals with different wavelengths which are generated by the optical source in Fig. 5; the power of each signal can be adjusted individually.

### DETAILED DESCRIPTION OF THE INVENTION

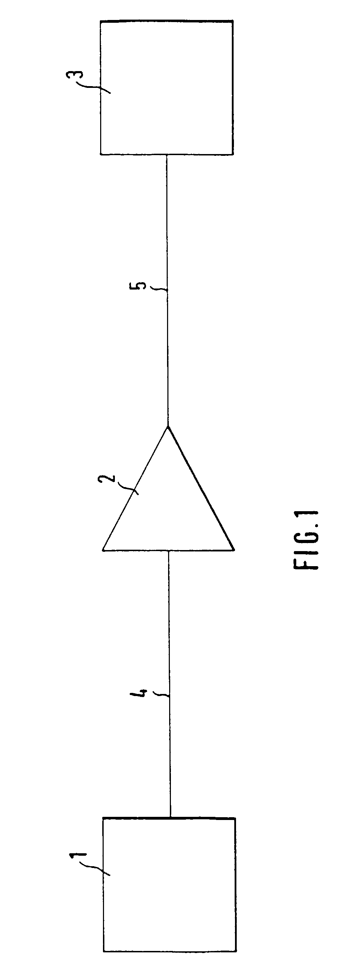

Fig. 1 shows a known arrangement for testing various parameters of an erbium-doped fiber amplifier (EDFA) 2. The output of a tunable laser 1 is connected with the input of EDFA 2 via an optical fiber 4. The output of EDFA 2 is connected with the input of an optical signal analyzer (OSA) 3 via an optical fiber 5. For analyzing the characteristics of the EDFA at different wavelengths, the tunable laser 1 is switched to a first wavelength for a first measurement. The optical signal analyzer 3 analyzes the various parameters of the EDFA, particularly gain and noise, and displays them to the operator. To analyze the characteristics of the EDFA under the influence of a signal with a second wavelength, the operator switches the tunable laser source 1 to a second wavelength and so on.

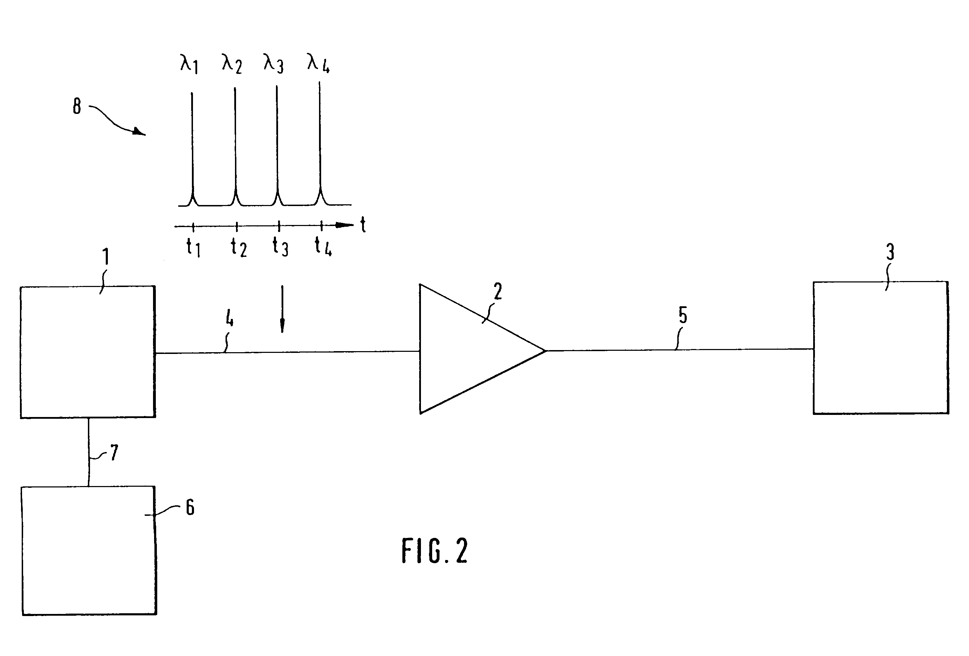

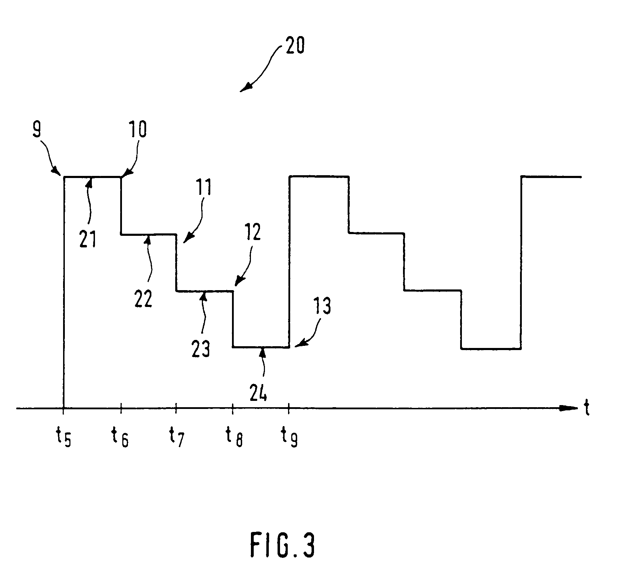

Fig. 2 is a block diagram of an apparatus arrangement for testing an optical device according to the invention. The output of a tunable laser 1 is connected with the input of the EDFA 2 via an optical fiber 4. The output of the EDFA is connected with the input of an optical signal analyzer (OSA) 3 via an optical fiber 5. The arrangement according to the invention further comprises a pattern generator 6. The output of the pattern generator 6 is connected via an electrical cable 7 with the control input of the tunable laser 1. The output signal of pattern generator 6, which will be described in more detail with regard to Fig. 3, controls the tunable laser 1 which generates multiple optical signals with different wavelengths λ1, λ2, λ3 and λ4. These multiple signals generated by the laser source 1 and applied to the optical fiber 4 are displayed in diagram 8.

The diagram 8 shows the appearance of the multiple wavelengths λ1 to λ4 generated by the laser source 1 as a function of time t. With the aid of the pattern generator 6, the laser source 1 generates a signal with the wavelengths λ1 at a time t1. Then the tunable laser 1 switches the signal with the wavelength λ1 off and switches a signal with the wavelength λ2 on at a time t2. In the next step, the laser source 1 switches the signal with the wavelength λ2 off and switches a signal with the wavelength λ3 on at a time t3. Then the laser source 1 switches the signal with the wavelength λ3 off and switches the signal with the wavelength λ4 on at a time t4. It will be understood that instead of a pattern generator any other device can be used which controls a tunable laser in the same manner as described.

Furthermore, it will be understood that more or less signals with different wavelengths can be generated by one or more tunable lasers depending on the wavelengths the device under test operates with. The time intervals between the different signals with the wavelengths λ1 to λ4 can be modified in a way that they are different. Furthermore, the time interval in which a first signal is switched on, can be longer than other time intervals. The power of the different signals can also be adjusted to different magnitudes. A wide range of variation of the different characteristics of the different signals and their time correlation allows to operate the device under test under various conditions in accordance with how they appear in practice. Many different test patterns can be memorized in the pattern generator.

All of the signals with different wavelengths λ1 to λ4 appear in a time interval t1 to t4 which is in the time interval of the recovery time of the amplifier 2. It will be understood that it is within the scope of the invention to generate various signals with different wavelengths within the recovery time of the specific device under test.

Fiber amplifiers (EDFAs, PDFAs etc.) are active optical components generating a noise signal at their output depending on the input signal and time.

When an optical signal is applied at the input of such amplifiers, the signal leads to a stimulated emission of photons - if the laser condition is fulfilled. The output signal is strong, since most of all photons are in a high energy level and are used to amplify the input signal which stimulates the photons to change their energy to a lower level and resulting to the emission of light which is coherent with the light at the input of the amplifier. Accordingly, there is only a low amount of photons in the high energy level available for a spontaneous emission of light. Thus, the noise level is low.

After switching off the input signal, the stimulation of photons stops. The amplifier still pumps the photons to a high energy level and since no photons are stimulated, the amount of photons which are available for a spontaneous emission of light (noise) increases during the mentioned recovery time. Within about 10 millisesconds (typical recovery time of an EDFA or PDFA), the noise signal increases from a very low level to a stable level.

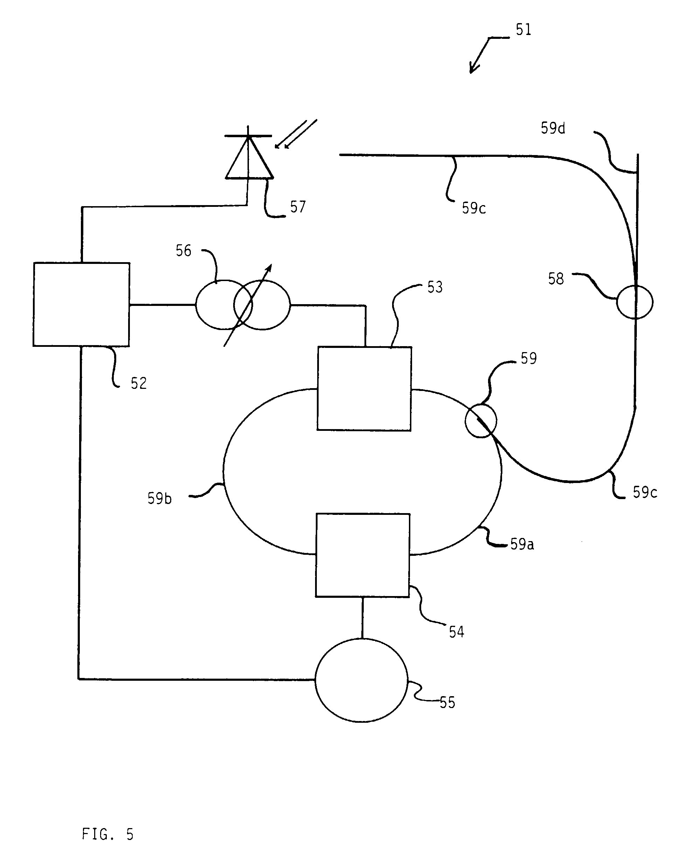

An optical source 51 according to the invention, shown in Figure 5 and which will be described later on in more detail, generates multiple optical signals and needs only a few microseconds to switch from one wavelength to another. Within this time interval, the noise level of the amplifier remains (nearly) at the same noise level like before switching off the input signal. Thus, due to the physics of the amplifier, the amplifier under test shows the same behavior under the set of test signals within the recovery time of the amplifier as under conditions in practice, where multiple signals with different wavelengths are present at the same time. The recovery time of the erbium-doped fiber amplifier 2 (EDFA) is in the range of 10 ms.

Fig. 3 depicts the control signal generated by the pattern generator 6 in Fig. 2 as a function of time. The control signal 20 which is applied to the laser source 1 comprises four steps 21 to 24 at different signal levels. At a time t5 the pattern generator 6 starts generating a control signal. When the signal level reaches a certain value, the controlled laser source 1 generates a signal with a wavelength λ1 for a short time as shown in Fig. 2. Then the control signal is kept constant from edge 9 to edge 10 as indicated by the first step 21. When the control signal drops at a time t6 which is shown at edge 10 the tunable laser 1 generates a signal with the wavelength λ2 for a short time. Then the control signal is kept constant from the time interval t6 to t7 indicated by the second step 22. When the control signal 20 drops again at edge 11, the laser source 1 generates a signal with the wavelength λ3 for a short time. From a time t7 to t8 the control signal is again kept constant as indicated by the third step 23. At the edge 12 the control signal 20 drops again, switching the tunable laser 1 to generate a signal with the wavelength λ4 for a short time. From t8 to t9 the control signal 20 is kept constant as shown by the fourth step 24 and at a time t9, indicated by edge 13 the pattern generator starts repeating the described control signal.

It will be understood that the shown control signal 20 can be easily modified if a tunable laser is used having different control signals than that described.

The time interval t5 to t9 is significantly lower than 10 ms to test the erbium-doped fiber amplifier 2 with a recovery time ≈ 10 ms. Accordingly, the frequency of the sequence of the steps 21 to 24 is significantly higher than 100 Hz, to operate the optical device at low recovery.

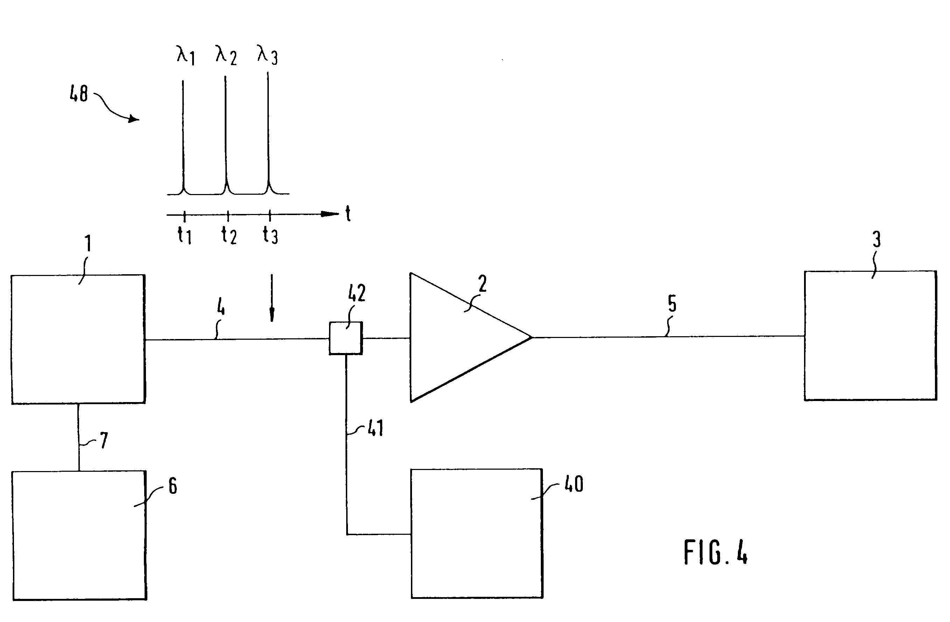

Fig. 4 shows a block diagram of a second arrangement for testing an optical device 2 comprising a further laser 40 with regard to Fig. 3, being separately adjustable. In addition to Fig. 2, Fig. 4 comprises a further laser 40, an optical fiber 41 and optical coupling means 42 coupling optical fiber 4 and optical fiber 41 to the input of the device under test, being an optical amplifier 2. As shown in diagram 48, tunable laser 1 generates optical signals with the wavelengths λ₁, λ₂ and λ₃. An optical signal with the wavelength ₄λ is generated by the separately adjustable laser 40. The arrangement according to Fig. 4 enables an optical signal with the wavelength λ₄ to be generated separately which allows modification of the optical signal, appropriate to the test conditions. Thus, a further degree of freedom in testing an optical device is achieved. It will be understood that further lasers can be used to substitute the optical signals generated by the time multiplexed tunable laser 1 to increase the degree of freedom in adjusting the test conditions.

Furthermore it will be understood that an optical device, such as an erbium-doped fiber amplifier, can be operated via a time multiplexed tunable laser source being triggered by signals to be transmitted optically (not shown). In another embodiment of the invention a tunable laser is triggered by a pattern generator but a further laser is triggered by the signals to be transmitted optically.

Fig. 5 shows an optical source 51 (a tunable laser), according to the invention, generating multiple optical signals to be applied to the device under test, such as an EDFA or PDFA having a recovery time.

Source 51 comprises a control unit 52, a gain medium 53, an electrically tunable filter 54, such as an acousto optical tunable filter (AOTF), a radio frequency generator 55, an adjustable source of current 56, a monitor unit 57 and beam splitters 58 and 59. Control unit 52 is equipped with a digital to analog converter and an analog to digital converter. Control unit 52 is connected with a data processor unit, such as a computer (PC) or the like and/or a pattern generator (not shown in Fig. 5). These means allow to trigger the control unit 52 to generate two output signals.

The first output signal adjusts the current source 56. Depending on the input signal of the control unit 52 from the data processor unit and/or pattern generator, the source of current 56 generates a current which is applied to the gain medium 53, such as a semiconductor amplifier, generating a coherent optical signal. The power level of the optical signal depends on the applied current.

The second output signal adjusts the radio frequency generator 55. Depending on the input signal of the control unit 52, the generator 55 generates an output signal with a certain frequency which is applied to the AOTF 54. The frequency characteristic of the AOTF depends on the frequency applied to the AOTF.

Gain medium 53 and electrically tunable filter 54 each have an input and an output for optical signals. The output of the gain medium 53 is connected with the input of the electrically tunable filter 54 via a fiber 59a. The output of the tunable filter 54 is connected with the input of the gain medium 53 via a fiber 59b. The connections between gain medium 53 and tunable filter are preferably made via polarization maintaining fiber (PMF) and in parallel beam. Preferably, gain medium 53, tunable filter 54 and fibers 59a, 59b are arranged to build up a ring cavity structure.

A beam splitter 59 for output power coupling is arranged in the ring cavity structure, preferably in the vicinity of the output of the gain medium 53. One end of fiber 59c is connected with beam splitter 59, while the other end 59d passes a second beam splitter 58 and is applied to the device under test (not shown in Fig. 5). One end of a fiber 59c is connected with the beam splitter 58 and the other end leads a part of the output signal of optical source 51 to a monitor unit, such as a monitor diode 57. Monitor diode 57 generates an electrical signal, dependent on the frequency and the intensity of the output signal of the optical source 51. Monitor diode 57 is connected with the control unit 52, in order to make optical source 51 to a selfadjusting system. It will be understood that the selfadjustment may be carried out by the control unit 52 itself and/or by a data processor (not shown) when using a comparator (not shown) comparing the desired signal values with the actual signal values.

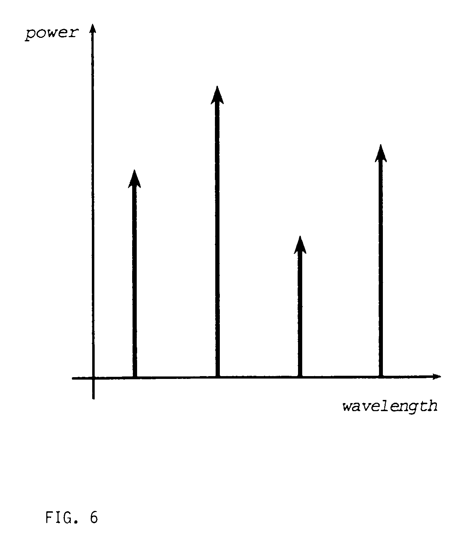

Fig. 6 shows a diagram with output laser power of the signals with different wavelengths which are generated by the optical source in Fig. 5.

According to the invention, wavelengths tuning, particularly in the range of 1.55 micrometer (µm), is achieved by an acousto optical tunable filter (AOTF) 54 as a wavelength filter. A change in wavelength as shown in Fig. 6 is achieved by changing the radio frequency (RF) of radio frenquency generator 55. According to the invention, this can be done very fast, therefore a change in the range of 10 microseconds is possible.

A change in power when switching to another wavelength as shown in Fig. 6 is carried out by changing the drive current of the semiconductor gain medium 53. According to the invention, a change in wavelength and an individual power setting for each wavelength can be carried out within about 12-15 microseconds.

Since this is very fast, the invention allows to set several wavelengths during the recovery time of the device under test (number of settable wavelengths = recovery time of the devices under test/wavelengths and power setting time for each wavelength). In WDM-applications 4, 8, 16 and probably more different wavelengths are needed.

## Claims

1. An optical source (51) comprising:
an optical gain medium (53),
an electrically tunable filter (54),
polarization maintaining fibers (59a, 59b), one fiber connecting the output of said gain medium with the input of said electrically tunable filter, and one fiber connecting the output of the electronically tunable filter with the input of said gain medium, and
a control unit (52) for controlling the frequency of a radio frequency generator (55) driving said electrically tunable filter,
characterized by:
a source of current (56) for driving said gain medium, whereby the control unit (52) controls the current of the source of current (56) in order to control the power of the optical source, and
a monitor unit (57) for generating an electrical signal dependent on the frequency and power of the output signal of said optical source, wherein said electrical signal is applied to the control unit.

2. The optical source as defined in claim 1, wherein said optical gain medium, said electrically tunable filter and said polarization maintaining fibers constitute a ring cavity.

3. The optical source as defined in claim 1, wherein the monitor unit (57) is a monitor diode.

4. The optical source as defined in any one of the above claims, wherein the optical gain medium (53) is a semiconductor amplifier.

5. The optical source as defined in any one of the above claims, wherein the electrically tunable filter (54) is an acousto optical tunable filter.

6. An arrangement for providing optical signals with different wavelengths comprising:
a single optical source (1) according to any one of the claims 1 - 3 for generating multiple optical signals having different wavelengths, and
switching means (6) for applying said multiple optical signals of said optical source (1) one after another to an optical device (2),
whereby said multiple optical signals are applicable to said optical device (2) one after another within the recovery time from the noise level of about 10 to 30 microseconds.

7. An arrangement for the measurement of the noise of an optical device (2), said optical device being of the type that is used to amplify multiple, optical signals with different wavelengths simultaneously, the arrangement comprising:
an arrangement according to claim 6 and analyzing means (3) analyzing a response signal of said optical device (2) to be tested.

## Patentansprüche

1. Optische Quelle (51), die Folgendes umfasst:
ein optisches Verstärkungsmedium (53),
ein elektrisch abstimmbares Filter (54),
die Polarisation aufrechterhaltende Lichtwellenleiter (59a, 59b), wobei ein Lichtwellenleiter den Ausgang des Verstärkungsmediums mit dem Eingang des elektrisch abstimmbaren Filters und ein Lichtwellenleiter den Ausgang des elektrisch abstimmbaren Filters mit dem Eingang des Verstärkungsmediums verbindet, und
eine Steuereinheit (52), um die Frequenz eines Hochfrequenzgenerators (55) zu steuern, der das elektrisch abstimmbare Filter ansteuert,
gekennzeichnet durch:
eine Stromquelle (56), um das Verstärkungsmedium anzusteuern, wobei die Steuereinheit (52) den Strom der Stromquelle (56) steuert, um die Leistung der optischen Quelle zu steuern, und
eine Überwachungseinheit (57), um ein elektrisches Signal zu erzeugen, das von der Frequenz und der Leistung des Ausgangssignals der optischen Quelle abhängt, wobei das elektrische Signal an die Steuereinheit angelegt wird.

2. Optische Quelle nach Anspruch 1, wobei das optische Verstärkungsmedium, das elektrisch abstimmbare Filter und die Lichtwellenleiter, welche die Polarisation aufrechterhalten, einen ringförmigen Hohlraum bilden.

3. Optische Quelle nach Anspruch 1, wobei die Überwachungseinheit (57) eine Überwachungsdiode ist.

4. Optische Quelle nach einem der vorstehenden Ansprüche, wobei das optische Verstärkungsmedium (53) ein Halbleiterverstärker ist.

5. Optische Quelle nach einem der vorstehenden Ansprüche, wobei das elektrisch abstimmbare Filter (54) ein akustooptisches abstimmbares Filter ist.

6. Anordnung zur Bereitstellung von optischen Signalen mit unterschiedlichen Wellenlängen, die Folgendes umfasst:
eine einzige optische Quelle (1) nach einem der Ansprüche 1 bis 3 zur Erzeugung von mehreren optischen Signalen, die unterschiedliche Wellenlängen haben, und
Schaltmittel (6), um die diversen optischen Signale der optischen Quelle (1) nacheinander an ein optisches Bauelement (2) anzulegen,
wobei die diversen optischen Signale innerhalb der ungefähr 10 bis 30 Mikrosekunden dauernden Erholungszeit vom Rauschpegel nacheinander an das optische Bauelement (2) angelegt werden können.

7. Anordnung zur Messung des Rauschens eines optischen Bauelements (2), wobei das optische Bauelement von dem Typ ist, der zur gleichzeitigen Verstärkung von mehreren optischen Signalen mit unterschiedlichen Wellenlängen verwendet wird, wobei die Anordnung Folgendes umfasst:
eine Anordnung nach Anspruch 6 und Auswertemittel (3), die ein Antwortsignal des optischen Bauelements (2), das geprüft werden soll, auswerten.

## Revendications

1. Une source optique (51) comprenant ;
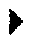 un milieu à gain optique (53),
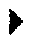 un filtre accordable électriquement (54),
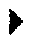 des fibres de conservation de polarisation (59a, 59b), une fibre assurant la liaison entre la sortie dudit milieu à gain et l'entrée du filtre accordable électriquement, et une fibre assurant la liaison entre la sortie du filtre accordable électroniquement, et l'entrée dudit milieu à gain, et
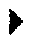 une unité de commande (52) pour commander la fréquence d'un générateur de radiofréquence (55) pilotant ledit filtre accordable électriquement,
caractérisé par :
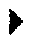 une source de courant (56) pour commander ledit milieu à gain, de manière que l'unité de commande (52) commande le courant de la source de courant (56) pour commander la puissance de la source optique, et
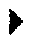 une unité de surveillance (57) pour générer un signal électrique dépendant de la fréquence et de la puissance du signal de sortie de ladite source optique, dans laquelle ledit signal électrique est appliqué à l'unité de commande.

2. La source optique selon la revendication 1, dans laquelle ledit milieu à gain optique, ledit filtre accordable électriquement et lesdites fibres de conservation de polarisation constituent une cavité annulaire.

3. La source optique selon la revendication 1, dans laquelle l'unité de surveillance (57) est une diode de surveillance.

4. La source optique selon l'une quelconque des revendications précédentes, dans laquelle le milieu à gain optique (53) est un amplificateur à semi-conducteur.

5. La source optique selon l'une quelconque des revendications précédentes, dans laquelle le filtre accordable électriquement (54) est un filtre accordable opto-acoustique.

6. Un dispositif de génération de signaux optiques ayant différentes longueurs d'onde, comprenant ;
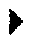 une source optique élémentaire (1) selon l'une quelconque des revendications 1 à 3, pour générer une pluralité de signaux optiques de longueurs d'onde différentes, et
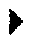 des moyens de commutation (6) pour appliquer ladite pluralité de signaux optiques de ladite source optique (1), l'un après l'autre, audit dispositif optique (2),
de manière que ladite pluralité de signaux optiques soient applicables audit dispositif optique (2) l'un après l'autre dans les limites du temps de rétablissement, depuis le niveau de bruit d'environ 10 à 30 microsecondes.

7. Un dispositif de mesure du bruit d'un dispositif optique (2), ledit dispositif optique étant du type utilisé pour amplifier simultanément une pluralité de signaux optiques ayant des longueurs d'onde différentes, le dispositif comprenant ;
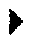 un dispositif selon la revendication 6 et des moyens d'analyse (3), analysant un signal de réponse dudit dispositif optique (2) à tester.
